# DEMANDE DE BREVET EUROPEEN

(11) **EP 1 291 990 A1**
(43) Date de publication de la demande: **12.03.2003**
(21) Numéro de dépôt: 02292132.4
(22) Date de dépôt: 29.08.2002
(51) Int. Cl.: H01S 5/50

(54) **Composant optique semiconducteur et procédé de fabrication d'un tel composant**

(30) Priorité: 05.09.2001 FR 0111638
(71) Demandeur: ALCATEL, 75008 Paris (FR)
(72) Inventeur: Goldstein Léon, 92370 Chaville (FR); Ougier Christophe, 92160 Antony (FR); Leclerc Denis, 91430 Igny (FR); Decobert Jean, 91620 Nozay (FR)
(74) Mandataire: Fournier, Michel

(57) **Abrégé**

La présente invention concerne le domaine des composants optiques semi-conducteurs. Plus particulièrement, elle concerne un composant optique semi-conducteur comportant une couche de confinement (6) en un matériau semi-conducteur contenant des dopants accepteurs (A) de sorte que le dopage est de type p, ladite couche étant déposée sur une autre couche semiconductrice (5) et définissant un plan parallèle à ladite autre couche. En outre, la concentration en dopage p de ladite couche de confinement (6) présente suivant l'une des directions (Z) contenues dans ledit plan au moins un gradient sensiblement distinct de zéro. L'invention concerne également un procédé de fabrication d'un tel composant.

## Description

La présente invention concerne le domaine des composants optiques semi-conducteurs. Plus particulièrement, elle concerne un composant optique semi-conducteur comprenant une couche de confinement en un matériau semi-conducteur dopé p ainsi qu'un procédé de fabrication d'un tel composant.

De manière connue, un composant optique semi-conducteur tel qu'un amplificateur optique semi-conducteur est souvent utilisé dans les sources de pompage de plusieurs watts pour une amplification notamment de type Raman de signaux optiques de type WDM (Wavelength Division Multiplexing en anglais) au moyen d'une fibre optique. Le fonctionnement d'un tel amplificateur est fondé sur l'utilisation d'une couche dite active qui, une fois alimentée en courant, assure l'amplification d'une onde optique injectée au fur et à mesure de sa propagation, onde de longueur d'onde généralement comprise entre 0,8 et 1,6 µm.

Un composant optique semi-conducteur comprend une couche de confinement disposée au-dessus de la couche active et contribuant au guidage de l'onde se propageant dans le composant. La couche de confinement est en un matériau semi-conducteur contenant des accepteurs d'électrons créant des porteurs libres positifs dits trous. La conduction électrique est alors majoritairement réalisée par ces trous : le dopage est dit de type p. Ce dopage permet notamment d'obtenir une couche de confinement semi-conductrice de résistance électrique inférieure à la résistance intrinsèque du semi-conducteur ce qui évite notamment un échauffement trop important du composant et assure une bonne injection de courant dans la couche active. Cependant, un tel dopage introduit des pertes dans le composant optique par exemple par photoabsorption. En effet, ces trous sont susceptibles d'absorber les photons émis par la couche active, limitant ainsi la puissance optique disponible du composant.

La couche de confinement définit un plan parallèle à la couche active. Dans les composants actuels, la concentration en dopants p est uniforme dans ce plan. Pour fixer la valeur de la concentration, un compromis est donc réalisé pour obtenir en même temps une résistance et des pertes globales les plus faibles possibles.

Or la probabilité de photoabsorption est d'autant plus grande que la puissance optique c'est-à-dire le nombre de photons est élevé. Ainsi, à une concentration en dopants p donnée, les pertes engendrées sont plus importantes dans certaines régions du composant optique. De même, la résistance intrinsèque de la couche de confinement peut varier localement par exemple lorsque l'épaisseur ou la largeur de la couche est variable.

La présente invention a donc pour objet de mettre au point un composant optique semi-conducteur comprenant une couche de confinement semi-conductrice dopée p ayant des propriétés opto-électriques optimisées dans chaque région afin d'augmenter les performances du composant.

A cet effet, la présente invention propose un composant optique semi-conducteur comportant une couche de confinement en un matériau semi-conducteur contenant des dopants accepteurs de sorte que le dopage est de type p, ladite couche étant déposée sur une autre couche semi-conductrice et définissant un plan parallèle à ladite autre couche,
**caractérisé en ce que** la concentration en dopage p de ladite couche de confinement présente suivant l'une des directions contenues dans ledit plan au moins un gradient sensiblement distinct de zéro.

Le ou les gradients sont déterminés en fonction des propriétés électro-optiques locales souhaitées dans le composant optique semi-conducteur selon l'invention.

Avantageusement, la direction peut être l'axe de propagation de la lumière, la puissance optique étant variable le long de cet axe.

Selon l'invention, le signe du gradient peut être négatif ce qui est avantageux dans une région nécessitant des pertes optiques minimum.

Dans un mode de réalisation de l'invention, le matériau semi-conducteur contient en outre des donneurs de concentration inférieure à la concentration en accepteurs sur toute la direction de sorte que le dopage reste de type p.

Dans cette configuration, la concentration en dopage p correspond à la différence entre la concentration en accepteurs et la concentration en donneurs. Le gradient de dopage peut ainsi être obtenu à partir d'un gradient de concentration en donneurs.

De préférence, les accepteurs peuvent être choisis parmi le zinc, le magnésium et le cadmium et les donneurs peuvent être choisis parmi le silicium ou le soufre.

Selon l'invention, le matériau semi-conducteur peut être choisi parmi les alliages de(s) colonne(s) III et/ou V du tableau périodique des éléments tels que les alliages à base d'InP et de GaAs.

Dans un mode de réalisation préféré de l'invention, le composant est un amplificateur optique semi-conducteur à guide évasé comportant un guide optique évasé de longueur L selon l'axe de propagation de la lumière disposé entre une face d'entrée et une face de sortie, le guide évasé comportant une région de section transversale ayant une surface constante dite section constante pour une propagation monomode de la lumière, la région de section constante débouchant sur une région de section transversale ayant une surface croissante dite section croissante pour une réduction de la densité de puissance optique de l'amplificateur optique semi-conducteur. En outre, la couche de confinement appartient au guide optique, et le gradient est négatif et est situé dans la région de section croissante selon l'axe de propagation.

La surface de la section croissante est supérieure celle de la section constante de sorte que la résistance dans la région de section croissante est inférieure à celle de la région de section constante. De plus, la puissance optique augmentant de la face d'entrée jusqu'à la face de sortie, les pertes optiques sont susceptibles d'être supérieures dans la région de section croissante. Il est donc avantageux de diminuer la concentration en dopage p dans cette région.

Dans une configuration de ce dernier mode de réalisation, le gradient est situé sur toute la région de section croissante pour une optimisation des performances du composant selon l'invention.

Avantageusement, la concentration en dopage p peut être minimale au niveau de la face de sortie de façon à augmenter la puissance optique disponible du composant selon l'invention.

En outre, dans ce dernier mode de réalisation, la concentration minimale est comprise entre 10¹⁷ cm⁻³ et 10¹⁸ cm⁻³ et est de préférence sensiblement égale à 3.10¹⁷ cm⁻³.

L'invention propose également un procédé de fabrication d'un composant optique semi-conducteur selon l'une des revendications précédentes, caractérisé en ce qu'il comporte les étapes successives suivantes :
- une étape dite de masquage par dépôt d'une couche de masquage en un matériau diélectrique de type silice sur une autre couche semi-conductrice,
- une étape d'élimination partielle de la couche de masquage de manière à créer une ouverture laissant apparente ladite autre couche,
- une étape de dépôt de la couche de confinement, la couche de confinement étant déposée sélectivement dans l'ouverture.

La couche de confinement selon l'invention est déposée sélectivement sur l'ouverture selon la technique SAG (Selective Area Growth en anglais) décrite dans l'article de A.M.Jones et al intitulé « Growth, Characterization, and Modeling of Ternary InGaAs-GaAs Quantum Wells by Selective Area Metalorganic Chemical Vapor Deposition » et paru dans le Journal of Electronic Materials, Vol 24, N°11, 1995, pages 1631-1636. La technique SAG est fondée sur le fait que les matériaux du type GaAs ou InP ne se dépose pas sur un masque d'oxyde de type silice et diffuse donc vers le substrat de type semi-conducteur.

Le procédé selon l'invention peut comporter en outre une étape de suppression totale de la couche de masquage ultérieure à l'étape de dépôt de la couche de confinement.

Le procédé de fabrication d'un composant selon l'invention peut comporter une étape de suppression partielle de la couche de confinement après l'étape de suppression totale.

Les caractéristiques et objets de la présente invention ressortiront de la description détaillée donnée ci-après en regard des figures annexées, présentées à titre illustratif et nullement limitatif.

Dans ces figures :
- la figure 1 représente une vue schématique de dessus d'un amplificateur optique semi-conducteur à guide évasé selon l'invention,
- la figure 2 représente une vue schématique en coupe du guide optique de l'amplificateur optique semi-conducteur à guide évasé de la figure 1 selon un plan perpendiculaire aux faces du guide G,
- la figure 3 représente le profil de concentration en dopage p d'une couche de confinement du guide optique de la figure 2 en fonction de la longueur du guide optique selon l'axe de propagation de la lumière Z,
- les figures 4 à 8 représentent les étapes d'un procédé de fabrication selon l'invention de l'amplificateur optique semi-conducteur à guide évasé de la figure 1.

Dans tout ce qui suit, le terme couche peut désigner une couche unique ou une superposition de couches remplissant la même fonction.

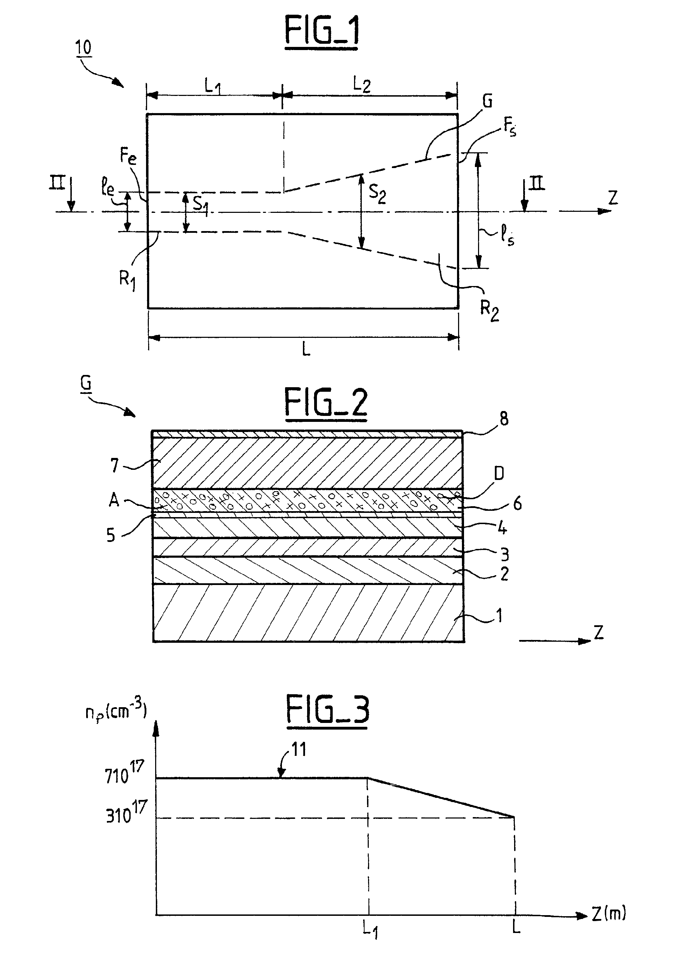

On a représenté en figure 1 une vue schématique de dessus d'un amplificateur optique semi-conducteur à guide évasé 10 selon l'invention utilisé par exemple dans une source de pompage pour une amplification de type Raman ou EDFA (Erbium Doped Fiber Amplifier en anglais) de signaux WDM au moyen d'une fibre optique .

L'amplificateur optique semi-conducteur à guide évasé 10 comporte un guide optique évasé G (en trait pointillé) de longueur L égale à 2 mm environ selon l'axe de propagation de la lumière Z. Le guide optique G est disposé entre une face d'entrée Fe de largeur le égale à 2 µm environ et une face de sortie Fs de largeur Is égale à 6 µm environ. Le guide G comporte une région R₁ de longueur L₂ et ayant une section transversale S₁ de surface constante dite section constante S₁ pour une propagation monomode de la lumière.

La région R₁ débouche sur une région R₂ de longueur L₂ égale à quelques centaines de microns et ayant une section transversale S₂ de surface croissante dite section croissante pour une réduction de la densité de puissance optique de l'amplificateur optique semi-conducteur 10.

Le guide optique évasé G est la région au coeur de l'invention.

Aussi, on a représenté en figure 2 une vue schématique en coupe du guide optique évasé de l'amplificateur optique semi-conducteur à guide évasé de la figure 1 selon un plan perpendiculaire aux faces du guide G.

Le guide optique évasé G comprend un support 1 en GaAs sur lequel est déposé par épitaxie de type MOVPE (Metal Organic Vapor Phase Epitaxy en anglais) :
- une couche de confinement dite inférieure 2 en un alliage semi-conducteur à base d'InP ou de GaAs dopé en donneurs d'électrons donc de type n,
- une couche tampon 3 semi-conductrice, favorisant la croissance des couches suivantes,
- une couche active 4 destinée à amplifier de la lumière, éventuellement à puits quantique en un alliage semi-conducteur à base d'InP ou de GaAs,
- une autre couche dite de protection 5 semi-conductrice d'épaisseur de l'ordre de 0,1 µm,
- une couche de confinement 6 selon l'invention en un alliage semi-conducteur à base d'InP ou de GAaS dopé n, d'épaisseur variant longitudinalement de 0,5 µm à 1 µm environ,
- une couche dite de contact 7 semi-conductrice fortement dopée p participant à la bonne injection de courant électrique,
- une couche de métallisation 8 métallique.

La couche de confinement 6 contient des accepteurs d'électrons A en zinc et, en moindre concentration, des donneurs d'électrons D en silicium. La concentration en dopage p notée nₚ correspondant à la différence entre la concentration en accepteurs A et celle en donneurs D.

La figure 3 montre une courbe 11 représentant le profil de concentration en dopage p notée nₚ de la couche de confinement 6 en fonction de la longueur L du guide optique évasé G selon l'axe de propagation Z.

La concentration nₚ est sensiblement constante dans la région R₁ donc sur toute la longueur L₁. Typiquement, elle est égale à environ 7.10¹⁷ cm⁻³. La concentration nₚ décroît sensiblement linéairement dans la région R₂ et présente donc un gradient négatif constant selon l'axe de propagation de la lumière Z. La valeur minimale de la concentration en dopage p est au niveau de la face de sortie Fs (voir figure 1) en Z=L et est sensiblement égale à 3.10¹⁷.

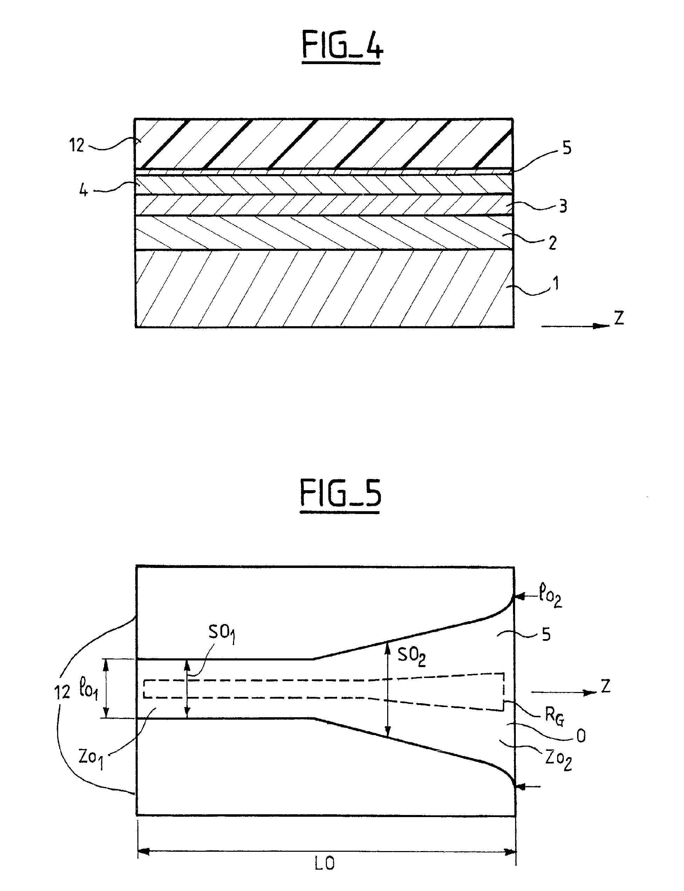

Les figures 4 à 8 représentent les étapes d'un procédé de fabrication de l'amplificateur optique semi-conducteur à guide évasé de la figure 1.

La figure 4 présente une coupe longitudinale de l'amplificateur optique semi-conducteur à guide évasé 10 obtenu après une série de dépôts successifs par épitaxie de type MOVPE sur une même face d'un support 1 de type GaAs:
- dépôt de la couche de confinement inférieure 2,
- dépôt de la couche tampon 3,
- dépôt de la couche active 4,
- dépôt de la couche de protection 5,

Le procédé comprend ensuite une étape dite de masquage par un dépôt de type PECVD (Plasma Enhanced Chemical Vapor Deposition en anglais) d'une couche de masquage 12 en un matériau diélectrique de type silice sur la couche de protection 5.

La figure 5 montre une vue du dessus de l'amplificateur optique semi-conducteur 10 obtenu après une étape d'élimination partielle de la couche de masquage 12 de manière à créer une ouverture O au-dessus de la couche de protection 5.

L'ouverture O comprend une première zone Zo₁ ayant une section transversale SO₁ de surface constante. La largeur Io₁ de la surface constante est de l'ordre de 10 µm. L'ouverture O comprend aussi une zone Zo₂ ayant une section transversale SO₂ de surface croissante. La largeur Io₂ de la surface croissante au niveau du bord B de l'ouverture O est de l'ordre de 20 à 50 µm. La longueur LO de l'ouverture O est sensiblement supérieure à la longueur L du guide optique G.

On a représenté dans l'ouverture 0 une région R_{G} en trait pointillé qui correspond à la région contenant la couche de confinement 6 une fois l'amplificateur optique semi-conducteur fini.

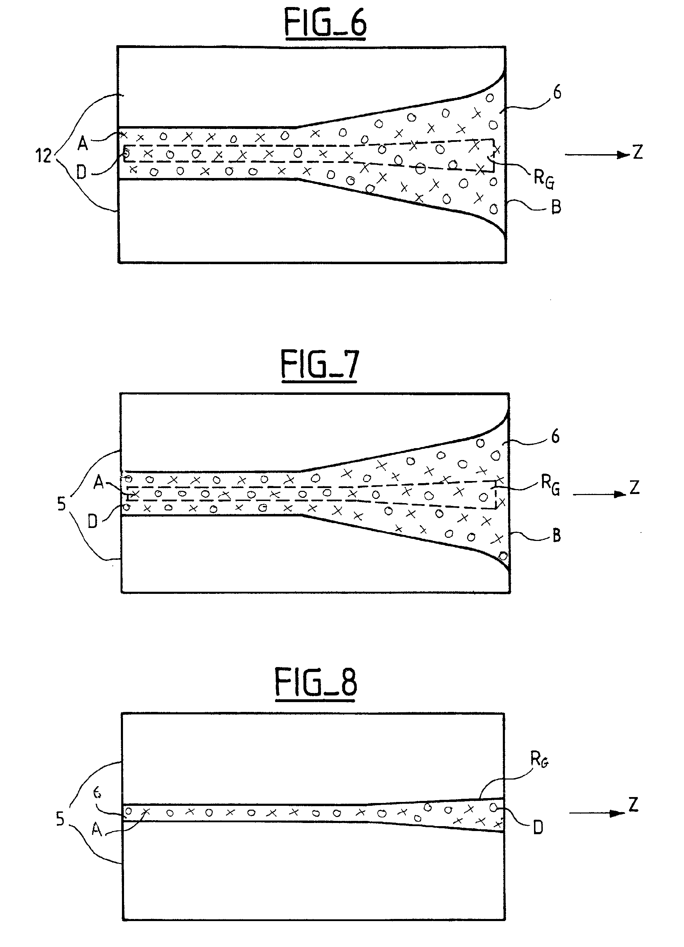

La figure 6 montre une vue du dessus de l'amplificateur optique semi-conducteur 10 obtenu après une étape de dépôt de la couche de confinement 6 par MOVPE.

La couche de confinement 6 est déposée sélectivement sur l'ouverture O selon la technique SAG. Les atomes d'InP ou de GaAs n'adhérant pas sur la silice, il se produit une diffusion latérale des atomes vers l'ouverture O. La zone Zo₁ étant plus étroite que la zone Zo₂, la diffusion est plus importante dans la zone Zo₁ de sorte que la vitesse de croissance moyenne V₁ dans cette zone Zo₁ peut être environ deux fois supérieure à la vitesse de croissance moyenne V_{2.}

A titre d'exemple v₁ et v₂ valent respectivement 2 µm/h, 1 µm/h à une température de l'amplificateur optique semi-conducteur de l'ordre de 600°C et pour un flux donné contenant de l'In et du P ou du Ga et de l'As. Pour un temps de dépôt de l'ordre de 30 minutes, les épaisseurs moyenne de la couche 6 dans les zone Zo₁ et Zo₂ sont égales à environ 1 µm et 0,5 µm.

En outre, pour réaliser le dopage p, on ajoute au flux d'InP ou de GaAs un flux comprenant des accepteurs A tels que du zinc comme le flux de diéthyl zinc et un flux comprenant des donneurs D tels que du silicium comme le flux de silane.

La concentration en zinc étant quasiment indépendante de la vitesse de croissance elle est quasi identique dans le zones Zo₁ et Zo₂. Par contre, la concentration en silicium étant inversement proportionnelle à la vitesse de croissance V₁, V₂, elle est supérieure dans la zone Zo₂ et est maximale au niveau du bord B.

La concentration nₚ en dopage p est donc sensiblement constante dans la région Zo₁ le long de l'axe Z et est égale à environ 7.10¹⁷ cm⁻³. La concentration nₚ présente un gradient négatif constant dans la région Zo₂, le long de l'axe Z. La concentration np au niveau du bord B est sensiblement de l'ordre de 3.10¹⁷ cm⁻³.

La figure 7 montre une vue du dessus de l'amplificateur optique semi-conducteur 10 obtenu après une étape de suppression totale de la couche de masquage 12 qui est ultérieure à l'étape de dépôt de la couche de confinement 6.

La figure 8 montre une vue en élévation de l'amplificateur optique semi-conducteur 10 obtenu après une étape de suppression partielle de la couche de confinement 6 en dehors de la région R_{G} afin de limiter la couche de confinement 6 dans le guide optique G.

Ensuite sont réalisées classiquement une série d'étapes de dépôt et de masquage, de gravure pour obtenir l'amplificateur optique semi-conducteur 10.

L'invention peut également s'appliquer à un composant optique semi-conducteur comportant un guide optique à section transversale constante ainsi qu'à toutes les catégories d'amplificateurs optiques semi-conducteur : amplificateur optique semi-conducteur à ruban enterré, amplificateur optique semi-conducteur à guidage par le gain et amplificateur optique semi-conducteur à guidage par l'indice.

L'invention peut aussi s'employer dans des composants optiques pour lesquels la densité de courant souhaitée est non uniforme, tels que certains composants à structure interférométrique de type Mach Zehnder. De cette façon, l'invention peut ainsi se substituer à la solution basée sur la conception d'une électrode dite distribuée.

En outre, on choisit la forme de l'ouverture O en fonction du ou des gradients selon l'invention souhaités. Ce ou ces gradients peuvent être constants ou variables le long de la direction choisie.

La ou les sections transversales d'un guide optique d'un composant optique semi-conducteur selon l'invention peuvent être rectangulaires ou trapézoïdales.

## Revendications

1. Composant optique semi-conducteur (10) comportant une couche de confinement (6) en un matériau semi-conducteur contenant des dopants accepteurs (A) de sorte que le dopage est de type p, ladite couche étant déposée sur une autre couche semi-conductrice (5) et définissant un plan parallèle à ladite autre couche,
**caractérisé en ce que** la concentration en dopage p (np) de ladite couche de confinement présente suivant l'une des directions contenues dans ledit plan (Z) au moins un gradient sensiblement distinct de zéro.

2. Composant optique semi-conducteur (10) selon la revendication 1
**caractérisé en ce que** ladite direction est l'axe de propagation de la lumière (Z).

3. Composant optique semi-conducteur (10) selon l'une des revendications 1 ou 2 **caractérisé en ce que** le signe dudit gradient est négatif.

4. Composant optique semi-conducteur (10) selon l'une des revendications 1 à 3 **caractérisé en ce que** ledit matériau semi-conducteur contient en outre des donneurs (D) de concentration inférieure à la concentration en accepteurs (A) sur toute ladite direction (Z).

5. Composant optique semi-conducteur (10) selon la revendication 4
**caractérisé en ce que** lesdits accepteurs (A) sont choisis parmi le zinc, le magnésium et le cadmium.

6. Composant optique semi-conducteur (10) selon l'une des revendications 4 ou 5 **caractérisé en ce que** lesdits donneurs (D) sont choisis parmi le silicium ou le soufre.

7. Composant optique semi-conducteur (10) selon l'une des revendications 1 à 6 **caractérisé en ce que** ledit matériau semi-conducteur est choisi parmi les alliages de(s) colonne(s) III et/ou V du tableau périodique des éléments tels que les alliages à base d'InP et de GaAs.

8. Composant optique semi-conducteur (10) selon l'une des revendications 1 à 7 **caractérisé en ce que** ledit composant est un amplificateur optique semi-conducteur à guide évasé comportant un guide optique évasé (G) de longueur L selon l'axe de propagation (Z) de la lumière disposé entre une face d'entrée (Fe) et une face de sortie (Fs),
**en ce que** ledit guide évasé comporte une région de section transversale (R₁) ayant une surface constante dite section constante (S₁) pour une propagation monomode de ladite lumière, ladite région de section constante débouchant sur une région de section transversale (R₂) ayant une surface croissante dite section croissante (S₂) pour une réduction de la densité de puissance optique dudit amplificateur optique semi-conducteur,
**en ce que** ladite couche de confinement (6) appartient audit guide optique et **en ce que** ledit gradient est négatif et est situé dans ladite région de section croissante selon ledit axe de propagation.

9. Composant optique semi-conducteur (10) selon la revendication 8
**caractérisé en ce que** ledit gradient est situé sur toute ladite région de section croissante (R₂).

10. Composant optique semi-conducteur (10) selon l'une des revendications 8 ou 9 **caractérisé en ce que** ladite concentration en dopage p (nₚ) est minimale au niveau de ladite face de sortie (Fs).

11. Composant optique semi-conducteur (10) selon la revendication 10 **caractérisé en ce que** ladite concentration minimale (nₚ) est comprise entre 10¹⁷ cm⁻³ et 10¹⁸ cm⁻³ et de préférence sensiblement égale à 3.10¹⁷ cm⁻³.

12. Procédé de fabrication d'un composant optique semi-conducteur (10) selon l'une des revendications précédentes **caractérisé en ce qu'**il comporte les étapes successives suivantes :
- une étape dite de masquage par dépôt d'une couche de masquage (12) en un matériau diélectrique de type silice sur une autre couche semi-conductrice (5),
- une étape d'élimination partielle de ladite couche de masquage de manière à créer une ouverture (O) laissant apparente ladite autre couche (5),
- une étape de dépôt de ladite couche de confinement (6), ladite couche de confinement étant déposée sélectivement dans ladite ouverture.

13. Procédé de fabrication d'un composant (10) selon la revendication 12 **caractérisé en ce qu'**il comporte en outre une étape de suppression totale de ladite couche de masquage (12) ultérieure à ladite étape de dépôt de ladite couche de confinement (6).

14. Procédé de fabrication d'un composant (10) selon la revendication 13 **caractérisé en ce qu'**il comporte en outre une étape de suppression partielle de ladite couche de confinement (6) après ladite étape de suppression totale.
